# EUROPEAN PATENT APPLICATION

(11) **EP 4 415 026 A1**
(43) Date of publication of application: **14.08.2024**
(21) Application number: 22878363.5
(22) Date of filing: 26.09.2022
(51) Int. Cl.: H01L 21/205, C30B 23/06, C30B 29/36

(54) **METHOD FOR ACHIEVING UNIFORM CARRIER CONCENTRATION IN EPITAXIAL LAYER, AND STRUCTURE CREATED BY MEANS OF SAID METHOD**

(30) Priority: 05.10.2021 JP 2021164360
(71) Applicant: Kwansei Gakuin Educational Foundation, Nishinomiya-shi, Hyogo 662-8501 (JP); Toyota Tsusho Corporation, Nagoya-shi Aichi 450-8575 (JP)
(72) Inventor: KANEKO, Tadaaki, Sanda-shi, Hyogo 669-1337 (JP); DOJIMA, Daichi, Sanda-shi, Hyogo 669-1337 (JP); TODA, Kohei, Sanda-shi, Hyogo 669-1337 (JP); SASAKI, Jun, Sanda-shi, Hyogo 669-1337 (JP); KOJIMA, Kiyoshi, Tokyo 108-8208 (JP)
(74) Representative: Dr. Schön, Neymeyr & Partner Patentanwälte mbB
(86) International application number: PCT/JP2022/035762
(87) International publication number: WO 2023/058493

(57) **Abstract**

An object of the present invention is to provide a novel technique for uniformizing a carrier concentration of an epitaxial layer.

The present invention is a method for uniformizing the carrier concentration of an epitaxial layer, the method including a growth step S10 of growing the epitaxial layer 20 under an equilibrium vapor pressure environment on the bulk layer 10. As described above, including the growth step S10 of growing the epitaxial layer 20 under an equilibrium vapor pressure environment can suppress the variation in the carrier concentration in the epitaxial layer 20.

## Description

### Technical Field

The present invention relates to a method for uniformizing a carrier concentration of an epitaxial layer and a structure prepared by the method.

### Background Art

As a next-generation semiconductor material replacing silicon (Si), compound semiconductors such as silicon carbide (SiC), gallium nitride (GaN), and gallium oxide (Ga₂O₃) have attracted attention.

For example, silicon carbide has a dielectric breakdown electric field that is one order of magnitude large, a band gap that is three times large, and a thermal conductivity that is about three times large compared to silicon. Therefore, silicon carbide is expected to be applied to power devices, high frequency devices, high temperature operation devices, and the like.

In order to achieve ultra-high withstand voltage and low loss in the semiconductor device, control of the impurity (dopant) concentration of an epitaxial layer needs to be appropriately performed. In view of such a problem, various methods of epitaxial growth for the purpose of controlling the impurity concentration have been proposed.

For example, Patent Literature 1 describes a technique of "a method for producing a silicon carbide semiconductor substrate, the method comprising: a step of supplying a hydrogen-containing gas into an epitaxial growth apparatus and heating an inside of the epitaxial growth apparatus for a predetermined time; and a step of transporting a single crystal silicon carbide substrate into the epitaxial growth apparatus and supplying a source gas, a carrier gas, and a dopant gas containing an impurity for determining a conductivity type to form a film of single crystal silicon carbide on the single crystal silicon carbide substrate by epitaxial growth".

Meanwhile, the inventors of the present application have developed a growth method different from the thermal CVD method and filed patent applications. For example, Patent Literature 2 describes a technique for growing an epitaxial layer of silicon carbide under an SiC-C equilibrium vapor pressure environment. In addition, Patent Literature 3 describes a technique for growing an epitaxial layer of silicon carbide under an SiC-Si equilibrium vapor pressure environment.

### Citation List

### Patent Literature

Patent Literature 1: JP 2019-121690 A
Patent Literature 2: WO 2020/095872 A
Patent Literature 3: WO 2020/095873 A

### Summary of Invention

### Technical Problem

One of the causes for deteriorating on-resistance characteristics is a variation in the carrier concentration of the epitaxial layer. When the carrier concentration varies in the plane of the epitaxial layer, this causes variation in threshold voltage and on-resistance of the semiconductor device. Furthermore, variations in the threshold voltage and the on-resistance cause not only a decrease in the energization capacity but also current concentration at a specific location, and thus may cause breakdown of the semiconductor device. Therefore, the carrier concentration of the epitaxial layer needs to be uniformized.

An object of the present invention is to provide a novel technique for uniformizing a carrier concentration of an epitaxial layer.

### Solution to Problem

The present invention to solve the above-described problem is a method for uniformizing a carrier concentration of an epitaxial layer, including a growth step of growing the epitaxial layer on a bulk layer under an equilibrium vapor pressure environment.

In a preferred mode of the present invention, a quantification step of quantifying an average value and a standard deviation of carrier concentrations is included.

In a preferred mode of the present invention, the quantification step includes a measurement step of measuring the carrier concentration at a plurality of measurement points of the epitaxial layer, and a calculation step of calculating an average value and a standard deviation of the carrier concentration from results of the plurality of measurement points.

In a preferred mode of the present invention, the growth step is a step of growing an epitaxial layer having a coefficient of variation of the carrier concentration of 0.05 or less.

In a preferred mode of the present invention, the growth step is a step of growing an epitaxial layer having a standard deviation of the carrier concentration of 1 × 10¹⁷ cm⁻³ or less.

In a preferred mode of the present invention, the growth step is a step of growing the epitaxial layer on a bulk layer having a diameter of at least 4 inches or more.

The present invention also relates to a method for producing a semiconductor substrate. That is, the present invention for solving the above-described problems is a method for producing a semiconductor substrate, including a growth step of growing an epitaxial layer on a bulk layer under an equilibrium vapor pressure environment.

The present invention also relates to a semiconductor substrate. That is, the present invention for solving the above-described problem is a semiconductor substrate in which a variation coefficient of the carrier concentration in an epitaxial layer is 0.05 or less. In addition, the present invention for solving the above-described problem is a semiconductor substrate in which a standard deviation of the carrier concentration in an epitaxial layer is 1 × 10¹⁷ cm⁻³ or less.

In a preferred mode of the present invention, it has a diameter of at least 4 inches or more.

The present invention also relates to a method for producing a semiconductor device. That is, the present invention to solve the above-described problem is a method for producing a semiconductor device, including: a growth step of growing an epitaxial layer on a bulk layer under an equilibrium vapor pressure environment to provide a substrate; and a device formation step of forming a device region on at least a part of the substrate.

The present invention also relates to a semiconductor device. That is, the present invention for solving the above-described problem is a semiconductor device including an epitaxial layer having a coefficient of variation of carrier concentration of 0.05 or less. In addition, the present invention for solving the above-described problems is a semiconductor device including an epitaxial layer having a standard deviation of the carrier concentration of 1 × 10¹⁷ cm⁻³ or less.

### Advantageous Effects of Invention

The disclosed technique can provide a novel technique for uniformizing the carrier concentration of the epitaxial layer.

Other objects, features, and advantages will become apparent from reading the following description of embodiments when taken in conjunction with the drawings and the claims.

### Brief Description of Drawings

Fig. 1 is an explanatory diagram for explaining a method for uniformizing a carrier concentration of an epitaxial layer according to an embodiment.
Fig. 2 is an explanatory diagram for explaining a method for uniformizing a carrier concentration of an epitaxial layer according to the embodiment.
Fig. 3 is an explanatory diagram for explaining a method for uniformizing a carrier concentration of an epitaxial layer according to the embodiment.
Fig. 4 is an explanatory diagram for explaining a method for measuring a carrier concentration of an epitaxial layer according to the present invention.
Fig. 5 is an explanatory diagram for explaining a method for uniformizing a carrier concentration of an epitaxial layer according to another embodiment.
Fig. 6 is an explanatory diagram for explaining the method for producing a semiconductor device according to an embodiment.
Fig. 7 is an explanatory diagram for explaining the method for producing a semiconductor device according to another embodiment.

### Description of Embodiments

Hereinafter, preferred embodiments of a method for uniformizing the carrier concentration of an epitaxial layer according to the present invention and a structure prepared by the method will be described in detail with reference to the accompanying drawings. The technical scope of the present invention is not limited to the embodiments illustrated in the accompanying drawings, and can be appropriately changed within the scope described in the claims. In the present description and the accompanying drawings, a layer or a region denoted with n or p means that electrons or holes are majority carriers, respectively. In addition, + and - added to n and p mean a higher impurity concentration and a lower impurity concentration than a layer and a region to which n and p are not added, respectively. The notations of n and p including + and - are the same, indicating that the concentrations are close, and the concentrations are not necessarily equal. In addition, in the present description, in the notation of the Miller indices, "-" means a bar attached to the index immediately after the index, and "-" is added in front of the index to represent a negative index. In the following description of the embodiments and the accompanying drawings, the same reference numerals are given to the same components, and redundant description is omitted.

### << Method for uniformizing carrier concentration of epitaxial layer>>

The method for uniformizing the carrier concentration of the epitaxial layer according to the present invention includes a growth step S10 of growing an epitaxial layer 20 on a bulk layer 10 under an equilibrium vapor pressure environment, and a quantification step S20 of quantifying an average value and a standard deviation of the carrier concentration of the epitaxial layer 20.

The present invention includes the growth step S10 of growing the epitaxial layer 20 under an equilibrium vapor pressure environment, thereby making it possible to suppress variations in the carrier concentration of the epitaxial layer 20. The variation in the carrier concentration may cause breakage of the semiconductor device, and thus uniformizing the carrier concentration may contribute to improvement of the yield of the semiconductor device.

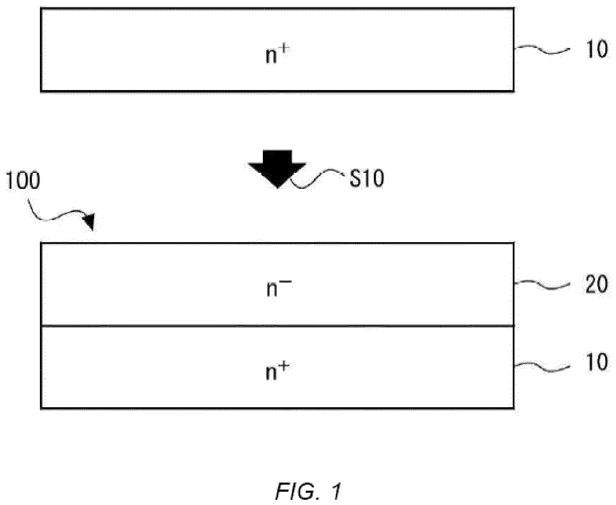

Fig. 1 is an explanatory diagram for explaining an embodiment of a method for uniformizing a carrier concentration of an epitaxial layer. The method for uniformizing the carrier concentration of the epitaxial layer according to the present embodiment includes a growth step S10 of growing a n⁻ type epitaxial layer 20 having a dopant concentration (doping concentration) lower than that of a n⁺ type bulk layer 10 on the n⁺ type bulk layer 10 of a compound semiconductor under an equilibrium vapor pressure environment.

### <Growth step S10>

Hereinafter, the growth conditions of the growth step S10 according to the embodiment will be described in detail.

### (Equilibrium vapor pressure environment)

The "equilibrium vapor pressure environment" in the present description refers to an environment of vapor pressure when the material of the bulk layer 10 and the source of the epitaxial layer 20 are in a phase equilibrium state via the gas phase.

Hereinafter, the growth step S10 for growing the epitaxial layer 20 of silicon carbide will be described in detail as an example.

An "equilibrium vapor pressure environment" in which the epitaxial layer 20 of silicon carbide is grown includes a "SiC-C equilibrium vapor pressure environment" and a "SiC-Si equilibrium vapor pressure environment".

The "SiC-C equilibrium vapor pressure environment" in the present description refers to a vapor pressure environment when SiC (solid phase) and C (solid phase) are in a state of phase equilibrium via a gas phase. This SiC-C equilibrium vapor pressure environment can be formed, for example, by heat-treating a semi-closed space in which an atomic ratio Si/C is equal to or less than 1. For example, the production apparatus and the growth conditions described in Patent Literature 2 can be adopted.

Specifically, in a case where a SiC substrate satisfying a stoichiometric ratio 1 : 1 is disposed in a SiC container satisfying a stoichiometric ratio 1 : 1, the atomic ratio Si/C in the container becomes 1. Furthermore, a C-vapor supply source (a C pellet or the like) may be disposed to make the atomic ratio Si/C equal to or less than 1. The container is disposed in which the atomic number ratio Si/C is 1 or less in this manner, so that a SiC-C equilibrium vapor pressure environment may be formed in the container.

The "SiC-Si equilibrium vapor pressure environment" in the present specification refers to a vapor pressure environment when SiC (solid phase) and Si (liquid phase) are in a state of phase equilibrium via a gas phase. This SiC-Si equilibrium vapor pressure environment is formed, for example, by heat-treating a semi-closed space in which an atomic ratio Si/C exceeds 1. For example, the production apparatus and the growth conditions described in Patent Literature 3 can be adopted.

Specifically, in a case where a SiC substrate satisfying a stoichiometric ratio 1 : 1 and a Si vapor supply source (a Si pellet or the like) are disposed in a SiC container satisfying a stoichiometric ratio 1 : 1, the atomic ratio Si/C in the container exceeds 1. The container is disposed in which the atomic number ratio Si/C is more than 1 in this manner, so that a SiC-Si equilibrium vapor pressure environment may be formed in the container.

The SiC-C equilibrium vapor pressure environment and the SiC-Si equilibrium vapor pressure environment in the present description include a near-thermal equilibrium vapor pressure environment that satisfies a relationship between a growth rate and a growth temperature derived from a theoretical thermal equilibrium environment.

In addition, in the present description, the "semi-closed space" refers to a space in which the inside of the container can be evacuated while at least a part of vapor generated in the container can be confined. This semi-closed space can be formed in the container.

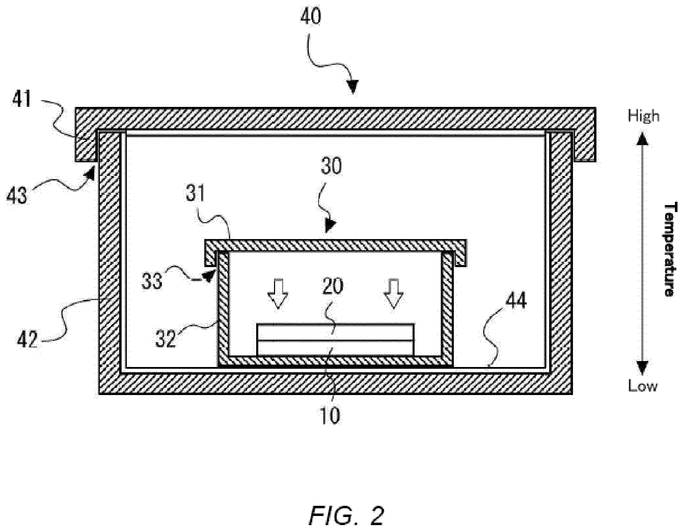

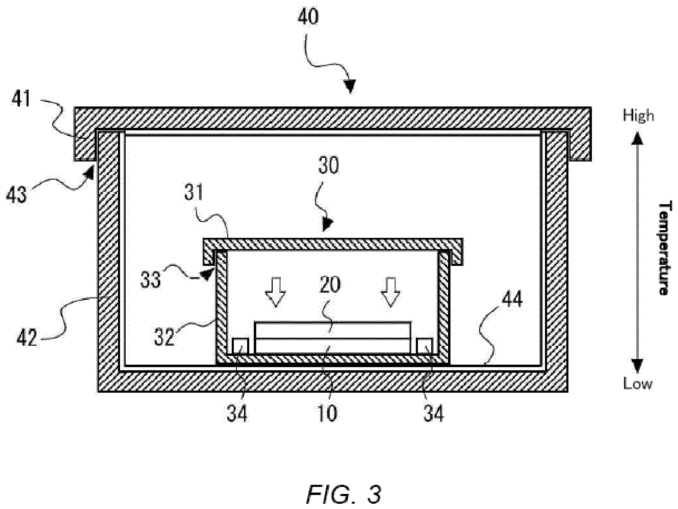

Figs. 2 and 3 are explanatory diagrams for explaining how the epitaxial layer 20 is grown using the production apparatus adopted in the method for growing silicon carbide according to the embodiment. A production apparatus that achieves an equilibrium vapor pressure environment includes a main container 30 that accommodates a base substrate (bulk layer 10) and a refractory material container 40 that accommodates the main container 30.

In a state where the base substrate (bulk layer 10) is accommodated in the main container 30 and the main container 30 is accommodated in the refractory material container 40, by heating with a temperature gradient so that the temperature of a base substrate side becomes low, atoms are supplied from a part of the main container 30 on a high temperature side to the base substrate, and the epitaxial layer 20 is formed.

Fig. 2 is an explanatory diagram for forming a SiC-C equilibrium vapor pressure environment with the atomic number ratio Si/C in the main container 30 set to 1 or less. Fig. 3 is an explanatory diagram for forming the SiC-Si equilibrium vapor pressure environment such that the atomic number ratio Si/C in the main container 30 is more than 1.

### (Bulk layer 10)

As the semiconductor material of the bulk layer 10, any desired material can be adopted as long as the material is a material of a generally used compound semiconductor. As an example, silicon carbide (SiC) will be described in detail, but other known group IV-IV compound semiconductor materials may be adopted. In addition, as the semiconductor material, a known group II-VI compound semiconductor material such as zinc oxide (ZnO), zinc sulfide (ZnS), zinc selenide (ZnSe), cadmium sulfide (CdS), or cadmium telluride (CdTe) may be adopted. In addition, as the semiconductor material, for example, a known group III-V compound semiconductor material such as boron nitride (BN), gallium arsenide (GaAs), gallium nitride (GaN), aluminum nitride (AlN), indium nitride (InN), gallium phosphide (GaP), indium phosphide (InP), or indium antimonide (InSb) may be adopted. In addition, as the semiconductor material, for example, an oxide semiconductor material such as aluminum oxide (Al₂O₃) or gallium oxide (Ga₂O₃) may be adopted. The bulk layer 10 may have a configuration in which known additive atoms used according to the material are added as appropriate.

The bulk layer 10 includes a wafer obtained by slicing an ingot prepared by a sublimation method or the like into a disk shape, or a substrate obtained by processing a single crystal of a compound semiconductor into a thin plate shape. As the single crystal polymorph of the compound semiconductor, any polytype can be adopted.

The dopant added to the bulk layer 10 only needs to be an element doped in a general semiconductor material. Specifically, examples of the dopant include nitrogen (N), phosphorus (P), aluminum (Al), and boron (B). In the embodiment, nitrogen or phosphorus in which the bulk layer 10 is n-type is adopted, but aluminum or boron in which the bulk layer 10 is p-type may be adopted.

The concentration of the dopant of the bulk layer 10 is preferably greater than 1 × 10¹⁷ cm⁻³, more preferably 1 × 10¹⁸ cm⁻³ or more, and still more preferably 1 × 10¹⁹ cm⁻³ or more.

The diameter of the bulk layer 10 is preferably 4 inches or more, more preferably 6 inches or more, and still more preferably 8 inches or more.

### (Epitaxial layer 20)

The epitaxial layer 20 is a layer in which variation in carrier concentration is suppressed. The standard deviation of the carrier concentration of the epitaxial layer 20 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and further preferably 3.0 × 10¹⁵ cm⁻³ or less.

In addition, the value of the coefficient of variation (standard deviation/average value) of the carrier concentration in the plane of the epitaxial layer 20 is preferably 0.05 or less, more preferably 0.04 or less, still more preferably 0.04 or less, still more preferably 0.02 or less, and still more preferably 0.01 or less.

As the material of the epitaxial layer 20, in addition to silicon carbide, any desired material can be adopted as long as the material is a material that can be epitaxially grown as a material of a general compound semiconductor. For example, the material of the epitaxial layer 20 may be a known material that can be adopted as the material of the bulk layer 10 described above, or may be a known material that can be epitaxially grown on the bulk layer 10.

Specifically, as a material of the epitaxial layer 20, for example, GaN, AlN, InN, ZnS, ZnSe, CdTe, GaP, GaAs, InP, InAs, InSb, or the like can be adopted. A combination of the material of the bulk layer 10 and the material of the epitaxial layer 20 can be selected as appropriate in consideration of a difference in lattice constant and thermal expansion coefficient between both materials.

The concentration of the dopant of the epitaxial layer 20 is preferably lower than 1 × 10¹⁷ cm⁻³, more preferably 1 × 10¹⁶ cm⁻³ or less, and still more preferably 1 × 10¹⁵ cm⁻³ or less.

### (Main container 30)

The main container 30 can accommodate the base substrate (bulk layer 10), and is configured to generate vapor pressure of a vapor phase species containing an element of a semiconductor material to be grown. For example, when the epitaxial layer 20 of silicon carbide is grown, the configuration may be such that vapor pressures of a vapor phase species containing a Si element and a vapor phase species containing a C element are generated in the internal space during the heat treatment. For example, the main container 30 is made of a material containing polycrystalline SiC. In the embodiment, the entire main container 30 is made of polycrystalline SiC. Heating the main container 30 made of such a material can generate vapor pressures of a gas phase species containing the Si element and a gas phase species containing the C element.

That is, it is desirable that the environment in the main container 30 subjected to the heat treatment is a vapor pressure environment of a mixed system of the gas phase species containing the Si element and the gas phase species containing the C element. Examples of the gas phase species containing the Si element include Si, Si₂, Si₃, Si₂C, SiC₂, and SiC. In addition, examples of the gas phase species containing the C element include Si₂C, SiC₂, SiC, and C. That is, SiC-based gas is present in the main container 30.

As a material of the main container 30, GaN, AlN, InN, ZnS, ZnSe, CdTe, GaP, GaAs, InP, InAs, InSb, or the like can be adopted. Adopting the main container 30 made of the same material as the epitaxial layer 20 to be grown can provide a desired epitaxial layer 20.

The dopant and dopant concentration of the main container 30 can be selected to suit the desired dopant and dopant concentration of the epitaxial layer 20. Adopting polycrystalline SiC having a dopant concentration lower than that of the bulk layer 10 as the material of the main container 30 can grow the epitaxial layer 20 having a dopant concentration lower than that of the bulk layer 10.

As long as a configuration is such that the vapor pressure of the gas phase species containing the Si element and the gas phase species containing the C element is generated in the internal space during the heating treatment of the main container 30, this structure can be adopted. For example, a configuration in which polycrystalline SiC is exposed on a part of the inner surface, a configuration in which polycrystalline SiC is separately disposed in the main container 30, or the like can be shown.

As illustrated in Figs. 2 and 3, the main container 30 is a fitting container including an upper container 31 and a lower container 32 that can be fitted to each other. The fitting container is configured such that a minute gap 33 is formed in a fitting portion between the upper container 31 and the lower container 32, so that the inside of the main container 30 can be exhausted (evacuated) from the gap 33. When it is desired to perform heating under the SiC-Si equilibrium vapor pressure environment, the Si vapor supply source 34 is disposed and heated as illustrated in Fig. 3. Examples of the Si vapor supply source 34 include a solid of Si (a piece of single-crystal Si or a Si pellet of Si powder or the like) and a Si compound.

The growth step S10 is a step of transporting Si atoms and C atoms of the main container 30 to the surface of the bulk layer 10 with a temperature difference provided between the bulk layer 10 and the main container 30 as a driving force. That is, at least a part (for example, the top surface of the upper container 31) of the main container 30 has a higher temperature than the bulk layer 10 does due to the temperature gradient formed by the heating furnace, so that a driving force is generated for transporting the source to the bulk layer 10.

Specifically, heating is performed so that the temperature on the bulk layer 10 side is low and the temperature on the upper container 31 side is high when the temperature of the surface of the bulk layer 10 is compared with the temperature of the top surface of the upper container 31 facing the bulk layer 10. As described above, forming a space provided with a temperature difference between the bulk layer 10 and the upper container 31 in the main container 30 can transport Si atoms and C atoms of the upper container 31 to the bulk layer 10 with the temperature difference as a driving force.

### (Refractory material container 40)

The refractory material container 40 includes a refractory material. For example, examples thereof include: C, which is a general-purpose heat resistant member; W, Re, Os, Ta, and Mo, which are refractory metals; Ta₉C₈, HfC, TaC, NbC, ZrC, Ta₂C, TiC, WC, and MoC, which are carbides; HfN, TaN, BN, Ta₂N, ZrN, and TiN, which are nitrides; HfB₂, TaB₂, ZrB₂, NB₂, and TiB₂, which are borides; polycrystal SiC; or a material similar to the main container 30.

Similarly to the main container 30, the refractory material container 40 is a fitting container including an upper container 41 and a lower container 42 that can be fitted to each other, and is configured to be capable of accommodating the main container 30. A minute gap 43 is formed in a fitting portion between the upper container 41 and the lower container 42, so that the inside of the refractory material container 40 can be exhausted (evacuated) from the gap 43.

The refractory material container 40 includes a vapor supply source that generates therein a vapor pressure of a vapor phase species containing an element of a semiconductor material to be grown. For example, when the epitaxial layer 20 of silicon carbide is grown, there is provided the Si vapor supply source 44 capable of supplying vapor pressure of vapor phase species containing Si element into the refractory material container 40. The Si vapor supply source 44 may have a configuration such that Si vapor is generated in the refractory material container 40 during the heating treatment, and examples thereof include a solid of Si (a piece of single-crystal Si or a Si pellet of Si powder or the like) and a Si compound. For example, a layer obtained by silicidation of a refractory material may be provided inside the above-described refractory material container 40.

In addition, as long as a configuration is such that the vapor pressure of a vapor phase species containing the Si element is formed in the refractory material container 40 during the heat treatment, the configuration can be adopted.

### <Quantification step S20>

The quantification step S20 includes a measurement step S21 of measuring a carrier concentration at a plurality of measurement points P of the epitaxial layer 20, and a calculation step S22 of calculating an average value and a standard deviation from results of the plurality of measurement points P.

As a method of measuring the carrier concentration in the measurement step S21, Raman spectroscopy or capacity (C-V) measurement can be adopted. In addition, any method capable of measuring the carrier concentration of the epitaxial layer 20 can be naturally adopted.

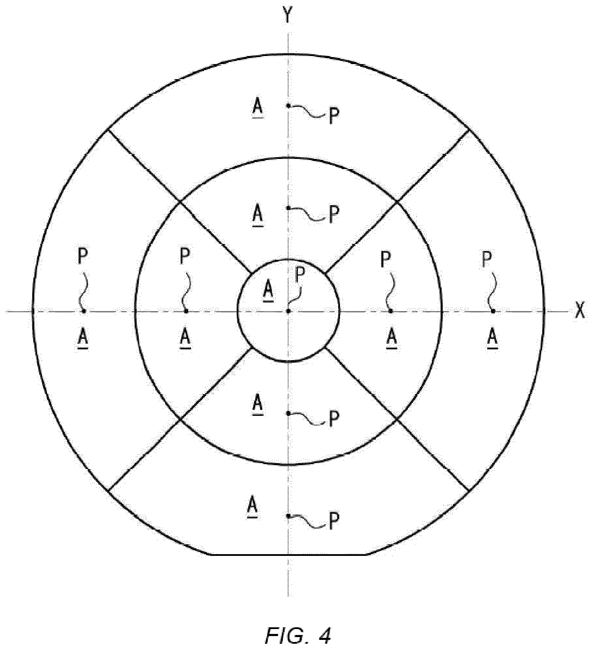

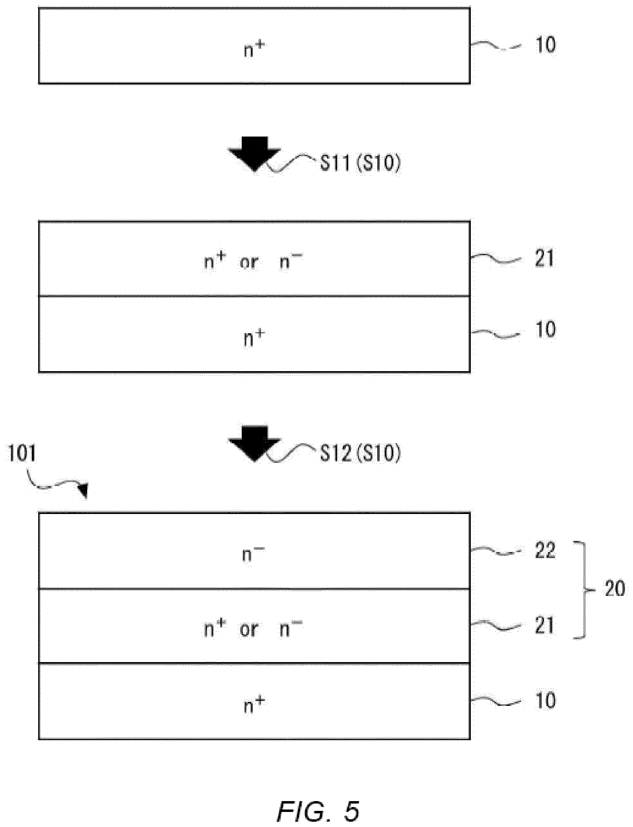

In the measurement step S21, as illustrated in Fig. 4, it is desirable that the entire region of the epitaxial layer 20 is divided into a plurality of sections to set an optional area A, and the measurement point P is disposed for each optional area A. In this optional area A, at least five or more sections are desirably set, and Fig. 5 illustrates a state in which nine optional areas A are set.

In Fig. 4, the fan-shaped optional area A is set on a concentric circle, but can be set in an optional shape/area such as a lattice shape or a spiral shape.

The calculation step S22 is a step of calculating an average value and a standard deviation from the carrier concentrations of the plurality of measurement points P obtained in the measurement step S21. In addition, the coefficient of variation may be calculated by dividing the obtained standard deviation by the average value. In this manner, calculating the standard deviation and the coefficient of variation with the results of the plurality of measurement points P can quantify the variation in the carrier concentration in the epitaxial layer 20 and determine whether the substrate is suitable for producing a semiconductor device.

According to the method for uniformizing the carrier concentration of the epitaxial layer according to the embodiment, including the growth step S10 of growing the epitaxial layer 20 under an equilibrium vapor pressure environment can suppress the variation in the carrier concentration of the epitaxial layer 20.

The growth step S10 according to the present invention may include a step of growing at least one epitaxial layer 20 under an equilibrium vapor pressure environment. Therefore, when the two epitaxial layers 20 are grown under different growth conditions, the carrier concentration may be uniformized by growing any one layer under an equilibrium vapor pressure environment.

Fig. 5 is an explanatory diagram for explaining another embodiment of a method for uniformizing a carrier concentration of an epitaxial layer. The constituent elements that are basically the same as the constituent elements described in the previous embodiment are denoted by the same reference numerals, and the description thereof will be simplified.

The method for uniformizing a carrier concentration of an epitaxial layer according to another embodiment includes a growth step S10 of growing an epitaxial layer 20 on a bulk layer 10, and the growth step S10 includes: a first growth step S11 of growing an n⁺ type or n⁻ type first epitaxial layer 21 under an equilibrium vapor pressure environment; and a second growth step S12 of growing a n⁻type second epitaxial layer 22 having a dopant concentration lower than that of the bulk layer 10.

That is, as illustrated in Fig. 4, the epitaxial layer 20 according to another embodiment may include: the bulk layer 10, the first epitaxial layer 21 having a uniformized carrier concentration, and the second epitaxial layer 22 having a dopant concentration lower than that of the bulk layer 10.

In the first growth step S11, the n⁺ type first epitaxial layer 21 having a dopant concentration equivalent to that of the n⁺ type bulk layer 10 may be grown, or the n⁻ type first epitaxial layer 21 having a dopant concentration lower than that of the bulk layer 10 may be grown. That is, the dopant concentration of the first epitaxial layer 21 is preferably 1 × 10¹⁷ cm⁻³ or less, more preferably 1 × 10¹⁶ cm⁻³ or less, still more preferably 1 × 10¹⁵ cm⁻³ or less, and is preferably 1 × 10¹⁷ cm⁻³ or more, more preferably 1 × 10¹⁸ cm⁻³ or more, still more preferably 1 × 10¹⁹ cm⁻³ or more. As a growth method of the first growth step S11, a method similar to that of the previous embodiment can be adopted.

The first epitaxial layer 21 is a layer in which variation in carrier concentration is suppressed. The standard deviation of the carrier concentration of the first epitaxial layer 21 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and further preferably 3.0 × 10¹⁵ cm⁻³ or less.

In addition, the value of the coefficient of variation (standard deviation/average value) of the carrier concentration in the plane of the first epitaxial layer 21 is preferably 0.05 or less, more preferably 0.04 or less, still more preferably 0.04 or less, still more preferably 0.02 or less, and still more preferably 0.01 or less.

In the second growth step S12, a growth method different from that in the previous first growth step S11 can be adopted. For example, there may be adopted a known film forming method such as a physical vapor deposition method (PVD method) or a chemical vapor deposition method (CVD method).

The concentration of the dopant of the second epitaxial layer 22 is preferably lower than 1 × 10¹⁷ cm⁻³, more preferably 1 × 10¹⁶ cm⁻³ or less, and still more preferably 1 × 10¹⁵ cm⁻³ or less.

### <<Semiconductor substrate>>

The semiconductor substrates according to the present invention are substrates 100 and 101 produced with the method for uniformizing the carrier concentration of the epitaxial layer described above, and includes the epitaxial layer 20 in which the carrier concentration is uniformized. In a case where the entire bulk layer 10 is removed in the process of producing the substrate, the semiconductor substrate is constituted by the epitaxial layer 20.

As illustrated in Fig. 1, the semiconductor substrate 100 according to the embodiment includes one epitaxial layer 20 in which the carrier concentration is uniformized. In the epitaxial layer 20, variations in carrier concentration are suppressed in the in-plane direction. Specifically, the standard deviation of the carrier concentration of the epitaxial layer 20 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and further preferably 3.0 × 10¹⁵ cm⁻³ or less.

In addition, the value of the coefficient of variation (standard deviation/average value) of the carrier concentration in the plane of the epitaxial layer 20 is preferably 0.05 or less, more preferably 0.04 or less, still more preferably 0.04 or less, still more preferably 0.02 or less, and still more preferably 0.01 or less.

As illustrated in Fig. 4, the average value and the standard deviation of the carrier concentration are obtained by measuring the carrier concentration of the epitaxial layer 20 at a plurality of measurement points P and calculating the average value and the standard deviation from the results of the plurality of measurement points P. In Fig. 4, the entire region of the epitaxial layer 20 is divided into nine sections to set an optional area A, and the measurement point P is disposed for each optional area A.

The concentration of the dopant of the epitaxial layer 20 is preferably lower than 1 × 10¹⁷ cm⁻³, more preferably 1 × 10¹⁶ cm⁻³ or less, and still more preferably 1 × 10¹⁵ cm⁻³ or less.

As illustrated in Fig. 5, the substrate 101 according to another embodiment includes: the first epitaxial layer 21 in which the carrier concentration is uniformized; and the second epitaxial layer 22 having a lower dopant concentration than the bulk layer 10.

The first epitaxial layer 21 may be a n⁺ type epitaxial layer having a dopant concentration equivalent to that of the bulk layer 10, or may be a n⁻ type epitaxial layer having a dopant concentration lower than that of the bulk layer 10. That is, the dopant concentration of the first epitaxial layer 21 is preferably 1 × 10¹⁷ cm⁻³ or less, more preferably 1 × 10¹⁶ cm⁻³ or less, still more preferably 1 × 10¹⁵ cm⁻³ or less, and is preferably 1 × 10¹⁷ cm⁻³ or more, more preferably 1 × 10¹⁸ cm⁻³ or more, still more preferably 1 × 10¹⁹ cm⁻³ or more.

In the first epitaxial layer 21, variations in carrier concentration are suppressed in the in-plane direction. Specifically, the standard deviation of the carrier concentration measured at a plurality of points in the plane of the first epitaxial layer 21 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and further preferably 3.0 × 10¹⁵ cm⁻³ or less.

In addition, the value of the coefficient of variation (standard deviation/average value) of the carrier concentration in the plane of the first epitaxial layer 21 is preferably 0.05 or less, more preferably 0.04 or less, still more preferably 0.03 or less, still more preferably 0.02 or less, and still more preferably 0.01 or less.

The concentration of the dopant of the second epitaxial layer 22 is preferably lower than 1 × 10¹⁷ cm⁻³, more preferably 1 × 10¹⁶ cm⁻³ or less, and still more preferably 1 × 10¹⁵ cm⁻³ or less.

The diameter of the bulk layer 10 is preferably 4 inches or more, more preferably 6 inches or more, and still more preferably 8 inches or more.

### <<Method for producing semiconductor device>>

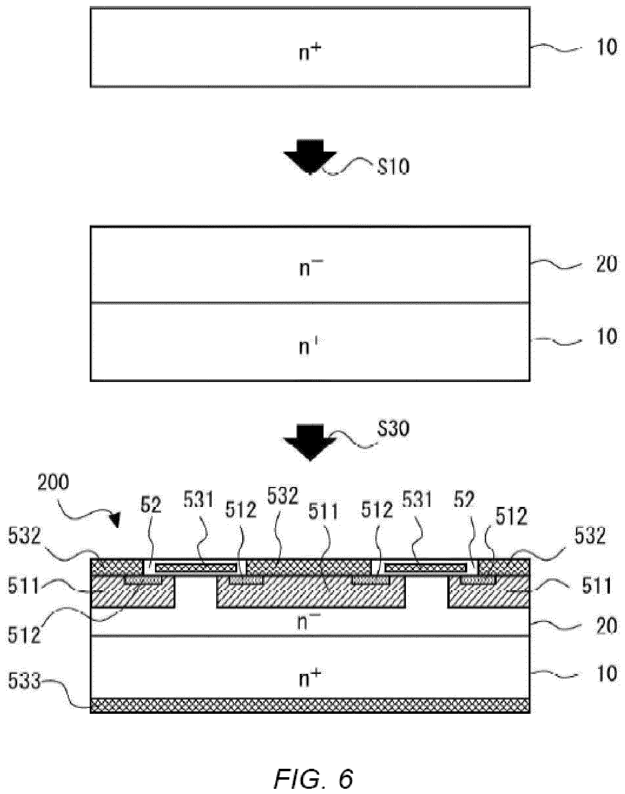

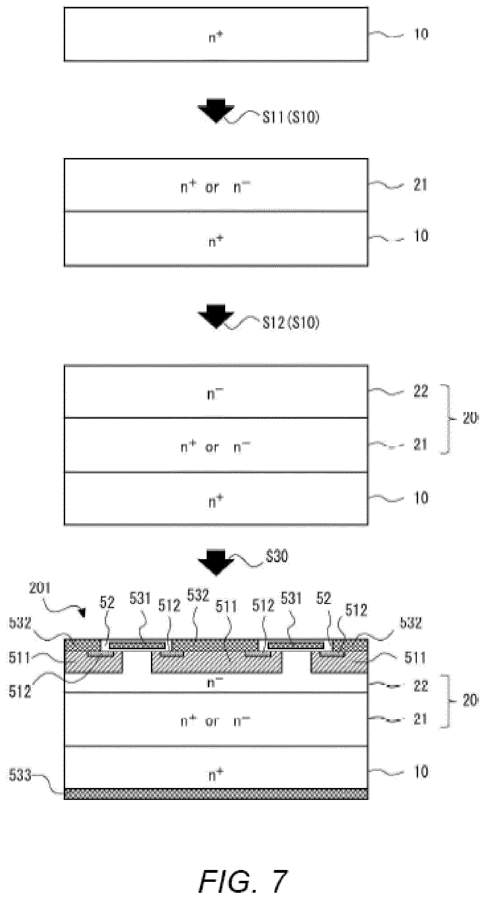

Fig. 6 is an explanatory diagram for explaining the method for producing a semiconductor device according to an embodiment. Fig. 7 is an explanatory diagram for explaining the method for producing a semiconductor device for silicon carbide according to another embodiment. The constituent elements that are basically the same as the constituent elements described in the previous embodiment are denoted by the same reference numerals, and the description thereof will be simplified.

As illustrated in Figs. 6 and 7, a method for producing a semiconductor device according to the embodiment and another embodiment includes: the growth step S10 of growing the epitaxial layer 20 on the bulk layer 10 under an equilibrium vapor pressure environment; and a device formation step S30 of forming a device region 50 in at least a part of a semiconductor substrate having the epitaxial layer 20.

The device region 50 is a structure required for functioning as a semiconductor device, and includes at least a doping region 51, an insulating film 52, and an electrode 53.

### <Device formation step S30>

The device formation step S30 includes: for example, a patterning step S31 of forming a circuit pattern on a substrate having the epitaxial layer 20; a doping step S32 of introducing the doping region 51 into the substrate with this circuit pattern; an insulating film formation step S33 of forming the insulating film 52; and an electrode formation step S34 of forming the electrode 53.

The patterning step S31 may, for example, include: a resist application step of applying a photoresist; an exposure step of exposing the photoresist through a photomask; a development step of developing the exposed photoresist; and a selective etching step of etching the exposed surface below the photoresist. Through these steps, a circuit pattern can be formed on the substrate.

The doping step S32 may, for example, include: an ion implantation step of irradiating the substrate with dopant ions that are ionized dopant atoms; and an activation step of performing an activation treatment by heat-treating the substrate irradiated with the dopant ions.

This step is a step of forming the doping region 51 by repeating the patterning step S31 and the doping step S32. The doping region 51 includes, for example, one or more of a n-type or p-type well region 511, a n-type or p-type contact region 512, a n-type or p-type drift region, a body region, a base region, a source region, a collector region, a field stop region, a pillar region, a buffer region, a recombination promoting region, and an embedded region.

The insulating film formation step S33 is a step of forming the insulating film 52. The insulating film 52 includes, as an example, one or more of a gate insulating film, an interlayer insulating film for element isolation, and a cap layer for adjusting a flat band voltage or the like in a gate electrode.

The electrode formation step S34 is a step of forming an electrode 53 for functioning as a semiconductor device. Examples of the electrode 53 include one or more of a gate electrode 531, a source electrode 532, a drain electrode 533, a base electrode, an emitter electrode, a collector electrode, an anode electrode, a cathode electrode, an ohmic electrode, and a Schottky electrode.

The device formation step S30 may further include a removal step S35 of removing at least a part of the bulk layer 10 from the back surface side. As described above, removing a part or the whole of the bulk layer 10 can reduce the thickness of the bulk layer 10 which is a conductive layer and contribute to reduction of on-resistance. In the removal step S35, a method for reducing the thickness of the bulk layer 10 can be adopted, and a known grinding method, a polishing method, an etching method, and the like can be exemplified.

### <<Semiconductor device>>

The semiconductor device according to the present invention is semiconductor devices 200 and 201 produced by using the method for uniformizing the carrier concentration of the epitaxial layer described above, and includes an epitaxial layer (epitaxial layer 20 or first epitaxial layer 21) in which the carrier concentration is uniformized, and a device region 50.

In the epitaxial layer (the epitaxial layer 20 or the first epitaxial layer 21), variation in carrier concentration is suppressed in the in-plane direction. Specifically, the standard deviation of the carrier concentration of the epitaxial layer is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and further preferably 3.0 × 10¹⁵ cm⁻³ or less.

In addition, the value of the coefficient of variation (standard deviation/average value) of the carrier concentration in the plane of the epitaxial layer is preferably 0.05 or less, more preferably 0.04 or less, still more preferably 0.03 or less, still more preferably 0.02 or less, and still more preferably 0.01 or less.

The semiconductor devices 200 and 201 according to these embodiments include the epitaxial layer (the epitaxial layer 20 or the first epitaxial layer 21) having an extremely small variation in carrier concentration, and thus can suppress the variation in threshold voltage and on-resistance and suppress a decrease in energization capability. Furthermore, breakdown of the semiconductor device due to current concentration at a specific location can be suppressed.

The semiconductor device includes, for example, a Schottky barrier diode, a junction barrier Schottky diode, a thyristor, a bipolar junction transistor, and a PiN diode.

### Examples

Hereinafter, the present invention will be described more specifically based on Examples and Comparative Examples. The present invention is not limited to the following contents.

An apparatus used in the following embodiment is an apparatus described in Patent Literature 2, and there was used the apparatus including the main container 30, the refractory material container 40, and a heating furnace that accommodates the main container 30 and the refractory material container 40 and is capable of heating so as to form a temperature gradient.

In Examples 1 to 5, the growth step S10 of growing the epitaxial layer 20 under an SiC-C equilibrium vapor pressure environment was performed on a silicon carbide substrate inclined at 4 degrees in a <11-20> direction of a 4-inch diameter. Thereafter, the quantification step S20 of quantifying the average value and the standard deviation of the carrier concentration was performed on the grown epitaxial layer 20.

In Comparative Examples 1 to 5, the quantification step S20 of quantifying an average value and a standard deviation of carrier concentrations was performed on a silicon carbide substrate inclined by 4 degrees in a <11-20> direction of a 4-inch diameter.

### <Growth step S10>

In the growth step S10, the silicon carbide substrate was accommodated in the main container 30, and the main container 30 was accommodated in the refractory material container 40 and heated at 1900 °C using a heating furnace.

As the main container 30, a container made of polycrystalline SiC was used. The atomic number ratio Si/C in the main container 30 with the substrate of silicon carbide disposed was 1. Specifically, the substrate of silicon carbide satisfying the stoichiometric ratio 1 : 1 was disposed in the main container 30 made of polycrystalline SiC satisfying the stoichiometric ratio 1 : 1, and thus the atomic number ratio Si/C in the main container 30 was 1. As described above, the epitaxial layer 20 was grown in the SiC-C equilibrium vapor pressure environment by heating the main container 30 in which the atomic number ratio Si/C in the container was 1. In the embodiment, the epitaxial layer 20 is grown in the SiC-C equilibrium vapor pressure environment, but the same effect can be expected even when the SiC-Si equilibrium vapor pressure environment is adopted.

As the refractory material container 40, a container made of TaC having a tantalum silicide layer on the inner side was used. It is configured such that Si vapor is supplied into the vessel from the tantalum silicide layer during the heat treatment, so that a Si vapor pressure environment is formed in the refractory material container 40.

### <Quantification step S20>

The carrier concentration of the epitaxial layer 20 grown in the growth step S10 was measured at nine measurement points P illustrated in Fig. 5 (measurement step S21). Specifically, the carrier concentration was measured at nine measurement points P including a measurement point P at the center, measurement points P at positions of 40 mm, 20 mm, -20 mm, and -40 mm from the center as a starting point along the X direction, and measurement points P at positions of 40 mm, 20 mm, -20 mm, and -40 mm along the Y direction. An average value, a standard deviation, and a coefficient of variation were calculated using these results (calculation step S22).

The results of Examples 1 to 5 and Comparative Examples 1 to 5 are listed in Table 1. E+15 in the table indicates × 10¹⁵, E+16 in the table indicates × 10¹⁶, and E+17 in the table indicates × 10¹⁸.

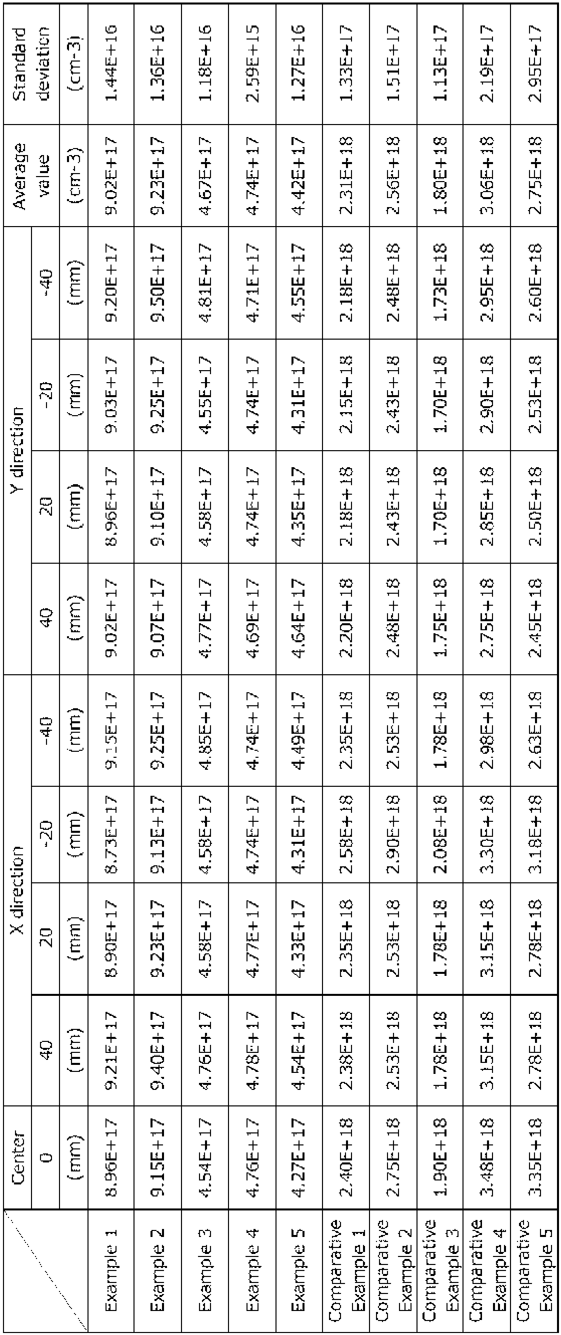

As listed in Table 1, the standard deviation of the carrier concentration of the epitaxial layer according to Comparative Examples 1 to 5 was 1.0 × 10¹⁷ cm⁻³ or more, whereas the standard deviation of the carrier concentration of the epitaxial layer according to Examples 1 to 5 was 1.0 × 10¹⁷ cm⁻³ or less. Specifically, the standard deviation of the carrier concentration of the epitaxial layer according to Examples 1 to 4 was 2.0 × 10¹⁶ cm⁻³ or less, and the standard deviation of the carrier concentration of the epitaxial layer according to Example 5 was 3.0 × 10¹⁵ cm⁻³ or less. From the above, it has been found that including the growth step of growing under an equilibrium vapor pressure environment can provide an epitaxial layer having a standard deviation of carrier concentration of 1.0 × 10¹⁷ cm⁻³ or less.

As listed in Table 1, the variation coefficient of the carrier concentration of the epitaxial layer according to Comparative Examples 1 to 5 was 0.05 or more, whereas the variation coefficient of the carrier concentration of the epitaxial layer according to Examples 1 to 5 was 0.05 or less. Specifically, the variation coefficient of the carrier concentration of the epitaxial layer according to Example 3 and Example 5 was 0.03 or less, the variation coefficient of the carrier concentration of the epitaxial layer according to Example 1 and Example 2 was 0.02 or less, and the variation coefficient of the carrier concentration of the epitaxial layer according to Example 4 was 0.01 or less. As described above, it has been found that including the growth step of growing under an equilibrium vapor pressure environment can provide an epitaxial layer in which the variation coefficient of the carrier concentration is 0.05 or less.

That is, in the semiconductor device produced using the semiconductor substrate having the epitaxial layer grown by the method for uniformizing the carrier concentration of the epitaxial layer according to the present invention, the variation in the carrier concentration in the epitaxial layer is suppressed, and the current concentration to a specific location that may cause the breakdown of the semiconductor device can be suppressed. Therefore, the yield of the semiconductor device can be improved.

### Reference Signs List

- 100, 101: Semiconductor substrate
- 200, 201: Semiconductor device
- 10: Bulk layer
- 20: Epitaxial layer
- 21: First epitaxial layer
- 22: Second epitaxial layer
- 30: Main container
- 31: Upper container
- 32: Lower container
- 33: Gap
- 34: Si vapor supply source
- 40: Refractory material container
- 41: Upper container
- 42: Lower container
- 43: Gap
- 44: Si vapor supply source
- 50: Device region
- 51: Doping region
- 52: Insulating film
- 53: Electrode
- S10: Growth step
- S20: Quantification step
- S21: Measurement step
- S22: Calculation step
- S30: Device formation step

## Claims

1. A method for uniformizing a carrier concentration of an epitaxial layer, the method comprising a growth step of growing an epitaxial layer on a bulk layer under an equilibrium vapor pressure environment.

2. The method according to claim 1, comprising a quantification step of quantifying an average value and a standard deviation of the carrier concentration.

3. The method according to claim 2, wherein
the quantification step includes:
a measurement step of measuring the carrier concentration at a plurality of measurement points of the epitaxial layer; and
a calculation step of calculating an average value and a standard deviation of the carrier concentration from results of the plurality of measurement points.

4. The method according to any one of claims 1 to 3, wherein the growth step is a step of growing an epitaxial layer having a coefficient of variation of the carrier concentration of 0.05 or less.

5. The method according to any one of claims 1 to 3, wherein the growth step is a step of growing the epitaxial layer having a standard deviation of the carrier concentration of 1 × 10¹⁷ cm⁻³ or less.

6. The method according to any one of claims 1 to 5, wherein the growth step is a step of growing the epitaxial layer on a bulk layer having a diameter of at least 4 inches or more.

7. A method for producing a semiconductor substrate with the method according to any one of claims 1 to 6.

8. A semiconductor substrate produced according to claim 7, wherein
a variation coefficient of the carrier concentration in the epitaxial layer is 0.05 or less.

9. A semiconductor substrate produced by the method according to claim 7, wherein
a standard deviation of the carrier concentration in the epitaxial layer is 1 × 10¹⁷ cm⁻³ or less.

10. A semiconductor substrate comprising an epitaxial layer having a coefficient of variation of carrier concentration of 0.05 or less.

11. A semiconductor substrate comprising an epitaxial layer having a standard deviation of the carrier concentration of 1 × 10¹⁷ cm⁻³ or less.

12. The substrate according to any one of claims 8 to 11, wherein the substrate has a diameter of at least 4 inches or more.

13. A method for producing a semiconductor device using a semiconductor substrate having an epitaxial layer grown by the method according to any one of claims 1 to 6, the method comprising
a device formation step of forming a device region in a part of the substrate.

14. A semiconductor device produced by the method according to claim 13, wherein
a variation coefficient of a carrier concentration of the epitaxial layer is 0.05 or less.

15. A semiconductor device produced by the method according to claim 13, wherein
a standard deviation of the carrier concentration of the epitaxial layer is 1 × 10¹⁷ cm⁻³ or less.

16. A semiconductor device comprising an epitaxial layer having a coefficient of variation of a carrier concentration of 0.05 or less.

17. A semiconductor device comprising an epitaxial layer having a standard deviation of the carrier concentration of 1 × 10¹⁷ cm⁻³ or less.
